# EUROPÄISCHE PATENTSCHRIFT

(11) **EP 0 909 467 B1**
(45) Veröffentlichungstag und Bekanntmachung des Hinweises auf die Patenterteilung: **18.10.2000**
(21) Anmeldenummer: 97925899.3
(22) Anmeldetag: 04.06.1997
(51) Int. Cl.: H01R 12/04, H01R 33/09, H05K 3/30, F21V 19/00, H01K 1/46, H01J 5/50, H01K 1/42, H01R 33/06

(54) **KLEINGLÜHLAMPE UND FASSUNG FÜR EINE KLEINGLÜHLAMPE**
SMALL FILAMENT LAMP, AND HOLDER FOR A SMALL FILAMENT LAMP
PETITE LAMPE A INCANDESCENCE ET SUPPORT POUR UNE TELLE LAMPE

(30) Priorität: 01.07.1996 DE 19626379
(43) Veröffentlichungstag der Anmeldung: 21.04.1999
(73) Patentinhaber: Patent-Treuhand-Gesellschaft für elektrische Glühlampen mbH, 81543 München (DE)
(72) Erfinder: HELBIG, Peter, D-89567 Sontheim (DE); STEINER, Hermann, D-89542 Herbrechtingen (DE)
(86) Internationale Anmeldenummer: DE9701122
(87) Internationale Veröffentlichungsnummer: WO9800883

(56) Entgegenhaltungen:
- EP-A- 0 522 633
- US-A- 3 335 387
- US-A- 4 595 859
- US-A- 5 139 433
- US-A- 5 513 082

## Beschreibung

Die Erfindung betrifft eine Kleinglühlampe und eine Fassung für eine Kleinglühlampe gemäß dem Oberbegriff des Patentanspruches 1.

Eine derartige Kleinglühlampe ist beispielsweise in der deutschen Offenlegungsschrift DE 44 01 487 offenbart. Dieses Dokument beschreibt einen Sokkel für eine Kleinglühlampe zum lösbaren und fixierbaren Einsetzen in eine als Fassung ausgebildete, mit randseitigen Erweiterungen versehene Öffnung einer Leiterplatine. Die elektrische Kontaktierung der Kleinglühlampe wird durch Anpressen der an die federnden Kontaktarme des Sockels geführten Lampenanschlußdrähte an die Leiterbahnen der Leiterplatine erreicht. Der Sockel ist von beiden Seiten in die dafür vorgesehene Öffnung der Leiterplatine einsetzbar und entnehmbar. Zu diesem Zweck besitzt der Sockel zwei unterschiedliche Einsetzmechanismen, nämlich einen Rastmechanismus und einen klemmenden Verdrehmechanismus. Der Aufbau und die Montage dieses Sockels sind vergleichweise aufwendig.

Es ist die Aufgabe der Erfindung, eine Kleinglühlampe und eine Fassung für eine Kleinglühlampe bereitzustellen, die einen verbesserten Sockel sowie verbesserte elektrische Kontakte besitzt, und die eine einfache Leiterplatinenmontage der Kleinglühlampe ermöglichen.

Diese Aufgabe wird erfindungsgemäß durch die kennzeichnenden Merkmale des Patentanspruchs 1 gelöst. Besonders vorteilhafte Ausführungen der Erfindung sind in den Unteransprüchen beschrieben.

Die aus dem Sockel herausgeführten elektrischen Kontakte der erfindungsgemäßen Kleinglühlampe sind als Blattfedern ausgebildet, die einerseits den elektrischen Kontakt zu den Fassungskontakten einer als Fassung für die Kleinglühlampe ausgebildeten Öffnung der Leiterplatine herstellen, indem sie auf den Fassungskontakten aufliegen, und die andererseits zur Halterung der Kleinglühlampe in der auf den Kleinglühlampensockel abgestimmten und als Fassung ausgebildeten Öffnung der Leiterplatine dienen, indem sie klemmend am Rand der Öffnung anliegen und so durch das Zusammenwirken mit einer am Sockel der Kleinglühlampe angebrachten, als Gegenlager wirkenden Abstützvorrichtung die Fixierung der Lampe in der Leiterplatinenöffnung ermöglichen. Die Fassungskontakte bestehen dabei vorteilhafterweise aus Leiterbahnen, die auf der Ober- oder Unterseite der Leiterplatine angebracht sind. Vorteilhafterweise umgreifen oder umklammern die als Blattfedern ausgebildeten Sockelkontakte den Rand der Leiterplatinenöffnung. Die Blattfedern weisen vorteilhafterweise mehrere abgewinkelte Abschnitte auf, wobei ein erster Abschnitt auf den als Leiterbahnen ausgebildeten Fassungskontakten auf der Ober- oder Unterseite der Leiterplatine aufliegt, während ein zweiter Abschnitt, der vom ersten Abschnitt abgewinkelt ist, in die Leiterplatinenöffnung eingreift und ein dritter Abschnitt, der vom zweiten Abschnitt abgewinkelt ist, an der Unterkante bzw. Oberkante des Randes der Leiterplatinenöffnung anliegt, so daß diese Blattfederabschnitte den Rand der Leiterplatinenöffnung umfassen. Ein Ende der Blattfedern ist vorteilhafterweise jeweils mit einer aus dem Lampenkolben herausgeführten Stromzuführung verbunden. Dieses Ende der Blattfedern ist vorteilhafterweise gabelartig ausgebildet und weist zwei Zinken mit konisch verengtem Zwischenraum auf, zwischen denen die Stromzuführungen klemmend fixiert sind. Der konisch verengte Zwischenraum zwischen den Zinken der gabelartigen Blattfederenden ermöglicht ein Anpassen der Sockelkontakte an unterschiedliche Durchmesser der aus dem Lampenkolben herausragenden Stromzuführungsdrähte. Die gabelartigen Blattfederenden sind vorteilhafterweise im Sockelkörper der Kleinglühlampe verankert. Zu diesem Zweck sind die Außenkanten der Zinken der gabelförmigen Blattfedernden vorteilhafterweise sägezahnförmig gestaltet. Die sägezahnförmigen Außenkanten der Zinken verkrallen sich am Sockelkörper und gewährleisten so eine sichere Verankerung der Sockelkontakte im Sockelkörper. Die als Gegenlager zu den Blattfedern wirkende, am Sockelkörper angebrachte Abstützvorrichtung besteht vorteilhafterweise aus einer oder mehreren gabelartigen Halterungen, die den Rand der Leiterplatinenöffnung umgreifen, oder aber aus einer auf die Leiterplatinendicke abgestimmten Nut, in die der Rand der Leiterplatinenöffnung eingreift.

Die erfindungsgemäße Kleinglühlampe kann sowohl von der Ober- als auch von der Unterseite der Leiterplatine her in die dafür vorgesehene Leiterplatinenöffnung eingesetzt und auch wieder entnommen werden. Die als Blattfedern ausgebildeten Sockelkontakte und die als Gegenlager wirkende Abstützvorrichtung bilden einen einfach zu bedienenden Schnappmechanismus. Eine an der den Sockelkontakten gegenüberliegenden Seite des Sockels angebrachte Schräge erleichtert das Einsetzen der Kleinglühlampe in die Leiterplatinenöffnung.

Nachstehend wird die Erfindung anhand eines bevorzugten Ausführungsbeispiels näher erläutert. Es zeigen:
- Figur 1: Eine Seitenansicht eines bevorzugten Ausführungsbeispiels der Erfindung
- Figur 2: Eine Draufsicht auf das in der Figur 1 abgebildete bevorzugte Ausführungsbeispiel der Erfindung
- Figur 3: Eine Seitenansicht des als Blattfeder ausgebildeten elektrischen Sockelkontaktes gemäß des in Figur 1 dargestellten bevorzugten Ausführungsbeispiels
- Figur 4: Eine Draufsicht auf das Ende der in Figur 3 gezeigten Blattfeder, das mit der aus dem Lampenkolben herausgeführten Stromzuführung verbunden ist

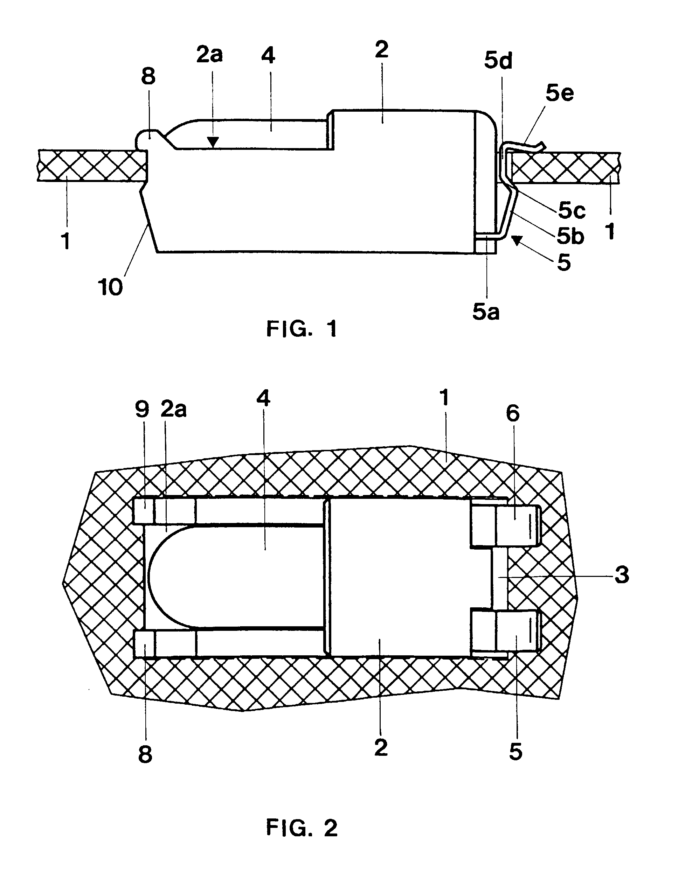

Bei dem in den Figuren 1-4 abgebildeten bevorzugten Ausführungsbeispiel handelt es sich um eine Kleinglühlampe, insbesondere eine sogenannte T5-Lampe, die zur Montage auf einer Leiterplatine 1 in eine auf den Sockel 2 der Kleinglühlampe abgestimmte, als Fassung für die Kleinglühlampe ausgebildete Leiterplatinenöffnung 3 vorgesehen ist. Derartige Kleinglühlampen werden zum Beispiel für die Armaturenbrettbeleuchtung in Kraftfahrzeugen verwendet. Die als Fassung dienende Leiterplatinenöffnung 3 ist rechteckig mit einer geringfügig größeren Länge als die Länge des Sockelkörpers 2. Die elektrischen Fassungskontakte werden von auf der Oberseite der Leiterplatine 1 angebrachten Leiterbahnen (nicht abgebildet) gebildet.

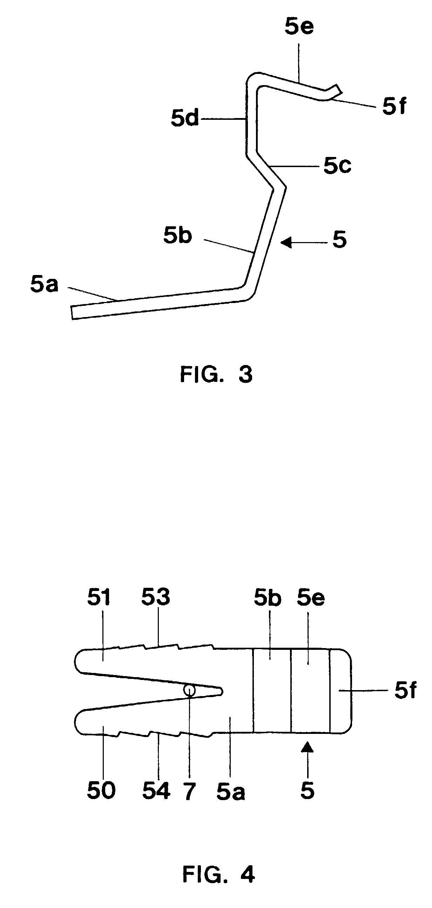

Die Kleinglühlampe gemäß des bevorzugten Ausführungsbeispiels besitzt einen im wesentlichen zylindrischen Sockel 2 aus Kunststoff, der mit einer Aufnahme für den ebenfalls im wesentlichen zylindrischen Lampenkolben 4 der Kleinglühlampe ausgestattet ist. Der Lampenkolben 4 ist axial in dem Sockelkörper 2 ausgerichtet. Der Sockel 2 weist auch eine einteilig mit dem Sockelkörper 2 ausgeführte, wannenartige Abschirmung 2a auf, in der der Lampenkolben 4 liegend angeordnet ist und die den Lampenkolben 4 auf seiner ganzen Länge teilweise umschließt. Die Tiefe der wannenartigen Abschirmung 2a ist größer als der Radius des Lampenkolbens 4, damit das von der Kleinglühlampe erzeugte Licht im wesentlichen nur zu einer Seite, das heißt zur Leiterplatinenoberseite bzw. Leiterplatinenunterseite abgegeben werden kann. Der Sockel 2 der Kleinglühlampen ist mit zwei elektrischen Kontakten 5, 6 versehen, die zur elektrischen Stromversorgung einer innerhalb des Lampenkolbens 4 angeordneten Glühwendel (nicht abgebildet) der Kleinglühlampe dienen. Die elektrischen Kontakte 5, 6 des Sockels 2, die künftig nur noch kurz als Sockelkontakte 5, 6 bezeichnet werden, werden jeweils von einer Blattfeder 5, 6 gebildet, die mehrere voneinander abgewinkelte Abschnitte aufweisen. Die Details der aus einem Federstahl gefertigten Blattfedern 5, 6 werden nachstehend exemplarisch anhand des in den Figuren 3 und 4 abgebildeten Sockelkontaktes 5 erläutert.

Die als Blattfedern ausgebildeten Sockelkontakte 5, 6 besitzen einen ersten, auf einer als Fassungskontakt ausgebildeten Leiterbahn auf der Oberseite der Leiterplatine 1 aufliegenden Abschnitt 5e, dessen Länge ungefähr 1,5 mm beträgt. Um ein Verkratzen der Leiterplatinenoberseite zu vermeiden, ist das freie Ende 5f des ersten Abschnittes 5e nach oben abgewinkelt. An den ersten Abschnitt 5e schließt sich ein zweiter, ca. 1,4 mm langer Abschnitt 5d an, der mit dem ersten Abschnitt 5e einen Winkel von ca. 75° bildet. Der zweite Abschnitt 5d greift in die Leiterplatinenöffnung 3 ein. Auf den zweiten Abschnitt 5d folgt ein in Richtung des ersten Abschnittes 5e zurückgebogener dritter Abschnitt 5c, der mit dem zweiten Abschnitt 5d einen Winkel von ungefähr 140° einschließt. Die Länge des dritten Abschnittes 5c beträgt ungefähr 0,8 mm. Er 5c liegt nach der Leiterplatinenmontage der Kleinglühlampe an der Unterkante des Randes der Leiterplatinenöffnung 3 an, so daß die drei abgewinkelten Abschnitte 5c, 5d, 5e den Rand der Leiterplatinenöffnung 3 klammerartig umfassen. Die Blattfeder 5 weist noch einen vierten 5b und einen fünften abgewinkelten Abschnitt 5a auf, von denen die eigentliche Federwirkung der Blattfeder 5 und damit der Klemmsitz der Lampe in der Leiterplatinenöffnung 3 ausgeht. Der vierte abgewinkelte Abschnitt 5b besitzt eine Länge von ca. 2,2 mm und bildet mit dem dritten Abschnitt 5c einen Winkel von 105°. Der fünfte Abschnitt 5a der Blattfeder 5 ist im Sockelkörper 2 verankert und mit einer aus dem Lampenkolben 4 herausgeführten Stromzuführung 7 sowohl mechanisch als auch elektrisch leitend verbunden. Der fünfte Abschnitt 5a ist ungefähr 3,8 mm lang und schließt mit dem vierten Abschnitt 5b einen Winkel von ungefähr 135° ein. Der fünfte abgewinkelte Abschnitt 5a ist gabelartig ausgebildet. Er 5a besitzt zwei Zinken 50, 51 mit einem konisch verengten Zwischenraum 52. Zwischen den Zinken 50, 51 ist die Stromzuführung 7 klemmend fixiert. Die Außenkanten 53, 54 der Zinken 50, 51 sind sägenzahnförmig ausgeführt.

An der den Sockelkontakten 5, 6 gegenüberliegenden Stirnseite des Sockels 2 ist der Sockelkörper mit zwei Abstützvorrichtungen 8, 9 ausgestattet. Diese beiden Abstützvorrichtungen sind als gabelartige Halterungen 8, 9 ausgebildet, die den Rand der Leiterplatinenöffnung 3 umgreifen und die den Blattfedern 5, 6 als Gegenlager dienen. Unterhalb der gabelartigen Halterungen 8, 9 ist die den Sockelkontakten 5, 6 gegenüberliegende Stirnseite des Sockels 2 abgeschrägt. Diese Schräge 10 erleichtert die Leiterplatinenmontage der Kleinglühlampe von der Leiterplatinenoberseite her.

Zur Erstbestückung der Leiterplatine 1 mit Kleinglühlampen wird die Kleinglühlampe von der Oberseite der Leiterplatine 1 her in die Leiterplatinenöffnung 3 hineingedrückt. Dabei werden die Blattfedern 5, 6 gegen den Sockelkörper 2 gepreßt und ihre abgewinkelten Abschnitte 5b sowie die an der gegenüberliegenden Sockelseite angebrachten Schräge 10 gleiten dabei über den Rand der Leiterplatinenöffnung 3 bis die Leiterplatinenkante in den gabelartigen Halterungen 8, 9 und den klammerartigen abgewinkelten Abschnitten 5c, 5d, 5e der Sockelkontakte 5, 6 einschnappt. Zum Herausnehmen wird die Kleinglühlampe innerhalb der Leiterplatinenöffnung 3 geringfügig in Richtung des mit den Blattfedern 5, 6 in Kontakt stehenden Randes der Leiterplatinenöffnung bewegt, so daß die Schnapp- bzw. Rastverbindung zwischen den gabelartigen Halterungen 8, 9 gelöst wird. Anschließend wird die Kleinglühlampe nach unten gekippt und vorzugsweise von der Unterseite der Leiterplatine 1 her aus der Leiterplatinenöffnung 3 entfernt. Auf analoge Weise, unter Umkehrung der Montageschritte, kann die Kleinglühlampe auch von der Unterseite der Leiterplatine 1 her in die Leiterplatinenöffnung 3 eingesetzt werden. Dieses Montageverfahren wird beim Austausch defekter Kleinglühlampen benutzt, wenn die Oberseite der Leiterplatine 1 nicht mehr zugänglich ist.

Die Erfindung beschränkt sich nicht auf das oben näher beschriebene Ausführungsbeispiel. Beispielsweise kann die den Blattfedern als Gegenlager dienende Abstützvorrichtung auch als eine auf die Dicke der Leiterplatine abgestimmte Nut oder Rille ausgebildet sein, in die der Rand der Leiterplatinenöffnung eingreift.

## Patentansprüche

1. Kleinglühlampe und Fassung für eine Kleinglühlampe, wobei die Fassung als eine auf den Sockel (2) der Kleinglühlampe abgestimmte Öffnung (3) einer Leiterplatine (1) ausgebildet ist und mit elektrischen Fassungskontakten ausgestattet ist, und wobei der Sockel (2) aus einem elektrisch isolierenden Material besteht und mit elektrischen Kontakten (5, 6) versehen ist, die zur elektrischen Kontaktierung mit den Fassungskontakten dienen,
dadurch gekennzeichnet, daß die elektrischen Kontakte des Sockels (2) als Blattfedern (5, 6) ausgebildet sind, wobei die Blattfedern (5, 6) auf den Fassungskontakten aufliegen und klemmend am Rand der Leiterplatinenöffnung (3) anliegen, so daß die Kleinglühlampe durch das Zusammenwirken der Blattfedern (5, 6) mit einer am Sockelkörper (2) angebrachten, als Gegenlager zu den Blattfedern (5, 6) dienenden Abstützvorrichtung (8, 9) in der als Fassung ausgebildeten Leiterplatinenöffnung (3) fixiert ist.

2. Kleinglühlampe und Fassung für eine Kleinglühlampe nach Anspruch 1, dadurch gekennzeichnet, daß die Blattfedern (5, 6) den Rand der Leiterplatinenöffnung (3) umgreifen oder umklammern.

3. Kleinglühlampe und Fassung für eine Kleinglühlampe nach Anspruch 1, dadurch gekennzeichnet, daß die Fassungskontakte von auf der Leiterplatine angebrachten Leiterbahnen gebildet werden.

4. Kleinglühlampe und Fassung für eine Kleinglühlampe nach Anspruch 1, dadurch gekennzeichnet, daß die Blattfedern (5, 6) mehrere abgewinkelte Abschnitte aufweisen, wobei
- ein erster Abschnitt (5e) auf Fassungskontakten auf der Oberseite oder Unterseite der Leiterplatine (1) aufliegt,
- ein zweiter Abschnitt (5d), der vom ersten Abschnitt (5e) abgewinkelt ist, in die Leiterplatinenöffnung (3) eingreift und ein dritter Abschnitt (5c), der vom zweiten Abschnitt (5d) abgewinkelt ist, an der Unterkante bzw. Oberkante des Randes der Leiterplatinenöffnung (3) anliegt, so daß diese Blattfederabschnitte (5c, 5d, 5e) den Rand der Leiterplatinenöffnung (3) umfassen.

5. Kleinglühlampe und Fassung für eine Kleinglühlampe nach Anspruch 4, dadurch gekennzeichnet, daß jeweils ein Ende (5a) der Blattfedern (5, 6) mit einer aus dem Lampenkolben (4) der Kleinglühlampe herausgeführten Stromzuführung (7) verbunden ist.

6. Kleinglühlampe und Fassung für eine Kleinglühlampe nach Anspruch 5, dadurch gekennzeichnet, daß die mit den Stromzuführungen (7) verbundenen Enden (5a) der Blattfedern (5, 6) gabelförmig ausgebildet sind und jeweils zwei Zinken (50, 51) aufweisen, zwischen denen die Stromzuführungen (7) klemmend fixiert sind.

7. Kleinglühlampe und Fassung für eine Kleinglühlampe nach Anspruch 6, dadurch gekennzeichnet, daß der Zwischenraum (52) zwischen den beiden Zinken (50, 51) des gabelförmigen Endes (5a) jeder Blattfeder (5, 6) konisch verengt ist.

8. Kleinglühlampe und Fassung für eine Kleinglühlampe nach Anspruch 6, dadurch gekennzeichnet, daß die Außenkanten (53, 54) der Zinken (50, 51) der gabelförmigen Blattfederenden (5a) sägezahnförmig ausgebildet ist.

9. Kleinglühlampe und Fassung für eine Kleinglühlampe nach Anspruch 4, dadurch gekennzeichnet, daß die mit den Stromzuführungen (7) verbundenen Blattfederenden (5a) im Sockel (2) verankert sind.

10. Kleinglühlampe und Fassung für eine Kleinglühlampe nach Anspruch 1, dadurch gekennzeichnet, daß die Abstützvorrichtung (8, 9) aus einer oder mehreren gabelartigen Halterungen (8, 9) besteht, die den Rand der Leiterplatinenöffnung (3) umgreifen.

11. Kleinglühlampe und Fassung für eine Kleinglühlampe nach Anspruch 1, dadurch gekennzeichnet, daß die Abstützvorrichtung von einer auf die Leiterplatinendicke abgestimmten Nut gebildet wird, in die der Rand der Leiterplatinenöffnung eingreift.

12. Kleinglühlampe und Fassung für eine Kleinglühlampe nach Anspruch 1, dadurch gekennzeichnet, daß die den elektrischen Kontakten (5, 6) des Sockels (2) gegenüberliegende Seite des Sockels (2) eine Schräge (10) aufweist.

13. Kleinglühlampe und Fassung für eine Kleinglühlampe nach Anspruch 1, dadurch gekennzeichnet, daß die Abstützvorrichtung (8, 9) und die Sockelkontakte (5, 6) auf einander gegenüberliegenden Seiten des Sokkels (2) angeordnet sind.

## Claims

1. Miniature incandescent lamp and a holder for a miniature incandescent lamp, the holder being constructed as an opening (3), coordinated with the cap (2) of the miniature incandescent lamp, of a printed circuit board (1), and being fitted with electric holder contacts, and the cap (2) consisting of an electrically insulating material and being provided with electric contacts (5) which serve to make electric contact with the holder contacts, characterized in that the electric contacts of the cap (2) are constructed as leaf springs (5, 6), the leaf springs (5, 6) resting on the holder contacts and bearing in a clamping fashion against the rim of the printed circuit board opening (3), with the result that the miniature incandescent lamp is fixed in the printed circuit board opening (3) constructed as holder by the cooperation of the leaf springs (5, 6) with a supporting device (8, 9) which is provided on the cap body (2) and serves as an abutment for the leaf springs (5, 6).

2. Miniature incandescent lamp and a holder for a miniature incandescent lamp according to Claim 1, characterized in that the leaf springs (5, 6) clasp or embrace the rim of the printed circuit board opening (3).

3. Miniature incandescent lamp and a holder for a miniature incandescent lamp according to Claim 1, characterized in that the holder contacts are formed by conductor tracks provided on the printed circuit board.

4. Miniature incandescent lamp and a holder for a miniature incandescent lamp according to Claim 1, characterized in that the leaf springs (5, 6) have a plurality of angled-off sections,
- a first section (5e) resting on holder contacts on the top side or underside of the printed circuit board (1), and
- a second section (5d), which is angled off from the first section (5e), engaging in the printed circuit board opening (3), and a third section (5c), which is angled off from the second section (5d), bearing against the lower edge or upper edge of the rim of the printed circuit board opening (3), with the result that these leaf spring sections (5c, 5d, 5e) grasp the rim of the printed circuit board opening (3).

5. Miniature incandescent lamp and a holder for a miniature incandescent lamp according to Claim 4, characterized in that in each case one end (5a) of the leaf springs (5, 6) is connected to a supply lead (7) led out of the lamp bulb (4) of the miniature incandescent lamp.

6. Miniature incandescent lamp and a holder for a miniature incandescent lamp according to Claim 5, characterized in that the ends (5a), connected to the supply leads (7), of the leaf springs (5, 6) are of fork-shaped construction and in each case have two prongs (50, 51) between which the supply leads (7) are fixed in a clamped fashion.

7. Miniature incandescent lamp and a holder for a miniature incandescent lamp according to Claim 6, characterized in that the interspace (52) between the two prongs (50, 51) of the fork-shaped end (5a) of each leaf spring (5, 6) is conically constricted.

8. Miniature incandescent lamp and a holder for a miniature incandescent lamp according to Claim 6, characterized in that the outer rims (53, 54) of the prongs (50, 51) of the fork-shaped leaf spring ends (5a) are of saw-tooth construction.

9. Miniature incandescent lamp and a holder for a miniature incandescent lamp according to Claim 4, characterized in that the leaf spring ends (5a) connected to the supply leads (7) are anchored in the cap (2).

10. Miniature incandescent lamp and a holder for a miniature incandescent lamp according to Claim 1, characterized in that the supporting device (8, 9) comprises one or more fork-like holders (8, 9) which clasp the rim of the printed circuit board opening (3).

11. Miniature incandescent lamp and a holder for a miniature incandescent lamp according to Claim 1, characterized in that the supporting device is formed by a groove which is coordinated with the printed circuit board thickness and in which the rim of the printed circuit board opening engages.

12. Miniature incandescent lamp and a holder for a miniature incandescent lamp according to Claim 1, characterized in that the side of the cap (2) situated opposite the electric contacts (5, 6) of the cap (2) has a bevel (10).

13. Miniature incandescent lamp and a holder for a miniature incandescent lamp according to Claim 1, characterized in that the supporting device (8, 9) and the cap contacts (5, 6) are arranged on mutually opposite sides of the cap (2).

## Revendications

1. Petite lampe à incandescence et douille pour une petite lampe à incandescence, la douille étant réalisée en ouverture (3) d'une platine (1) conductrice adaptée au culot (2) de la petite lampe à incandescence et étant munie de contacts de douille électriques, et le culot (2) étant en un matériau isolant du point de vue électrique et étant muni de contacts (5, 6) électriques qui servent à la mise en contact électrique avec les contacts de la douille, caractérisée en ce que les contacts électriques du culot (2) sont réalisés en ressorts (5, 6) à lame, les ressorts (5,-6) à lame reposant sur les contacts de la douille et étant en contact en le serrant avec le bord de l'ouverture (3) de la platine conductrice, si bien que la petite lampe à incandescence est immobilisée dans l'ouverture (3) de platine conductrice réalisée en douille, par la coopération des ressorts (5, 6) à lame avec un dispositif (8, 9) d'appui, monté sur le corps (2) du culot et servant de butée aux ressorts (5, 6) à lame.

2. Petite lampe à incandescence et douille pour une petite lampe à incandescence suivant la revendication 1, caractérisée en ce que les ressorts (5, 6) à lame serrent ou pincent le bord de l'ouverture (3) de la platine conductrice.

3. Petite lampe à incandescence et douille pour une petite lampe à incandescence suivant la revendication 1, caractérisée en ce que les contacts de douille sont formés par des pistes conductrices ménagées sur la platine conductrice.

4. Petite lampe à incandescence et douille pour une petite lampe à incandescence suivant la revendication 1, caractérisée en ce que les ressorts (5, 6) à lame comportent plusieurs tronçons coudés,
- Un premier tronçon (5e) reposant sur des contacts de douille du côté supérieur ou du côté inférieur de la platine 1 conductrice,
- Un deuxième tronçon (5d), qui est coudé par rapport au premier tronçon (5e), rentrant dans l'ouverture (3) de la platine conductrice et un troisième tronçon (5c), qui est coudé par rapport au deuxième tronçon (5d), s'appliquant à l'arrête inférieure ou à l'arrête supérieure du bord de l'ouverture (3) de la platine conductrice, si bien que ces tronçons (5c, 5d, 5e) de ressorts à lame entourent le bord de l'ouverture (3) de la platine conductrice.

5. Petite lampe à incandescence et douille pour une petite lampe à incandescence suivant la revendication 4, caractérisée en ce que chaque extrémité (5a) des ressorts (5, 6) à lame est reliée à une entrée (7) de courant, qui est sortie de l'ampoule (4) de la petite lampe à incandescence.

6. Petite lampe à incandescence et douille pour une petite lampe à incandescence suivant la revendication 5, caractérisée en ce que les extrémités (5a) des ressorts (5, 6) à lame reliées aux entrées (7) de courant sont réalisées en forme de fourche et comportent chacune deux dents (50, 51) entre lesquelles les entrées (7) de courant sont immobilisées en y étant serrées.

7. Petite lampe à incandescence et douille pour une petite lampe à incandescence suivant la revendication 6, caractérisée en ce que l'intervalle (52) entre les deux dents (50, 51) de l'extrémité (5a) en forme de fourche de chaque ressort (5, 6) à lame est rétréci de manière conique.

8. Petite lampe à incandescence et douille pour une petite lampe à incandescence suivant la revendication 6, caractérisée en ce que les bords (53, 54) extérieurs des dents (50, 51) (5a) des ressorts à lame en forme de fourche sont en dents de scie.

9. Petite lampe à incandescence et douille pour une petite lampe à incandescence suivant la revendication 4, caractérisée en ce que les extrémités (5a) de ressorts à lame reliées aux entrées (7) de courant sont ancrées dans le culot (2).

10. Petite lampe à incandescence et douille pour une petite lampe à incandescence suivant la revendication 1, caractérisée en ce que le dispositif (8, 9) de soutien est constitué d'une ou de plusieurs fixations (8, 9) en forme de fourche qui entourent le bord de l'ouverture (3) de la platine conductrice.

11. Petite lampe à incandescence et douille pour une petite lampe à incandescence suivant la revendication 1, caractérisée en ce que le dispositif de soutien est formé par une rainure qui est adaptée à l'épaisseur de la platine conductrice et dans laquelle rentre le bord de l'ouverture de la platine conductrice.

12. Petite lampe à incandescence et douille pour une petite lampe à incandescence suivant la revendication 1, caractérisée en ce que le côté du culot (2) faisant face aux contacts (5, 6) électriques du culot (2) comporte un biseau (10).

13. Petite lampe à incandescence et douille pour une petite lampe à incandescence suivant la revendication 1, caractérisée en ce que le dispositif (8, 9) de soutien et les contacts (5, 6) du culot sont disposés sur des côtés du culot (2) qui se font face.
